(19) Europäisches Patentamt
European Patent Office
Office européen des brevets

(11) **EP 2 377 174 B1**

(12) **EUROPEAN PATENT SPECIFICATION**

(45) Date of publication and mention
of the grant of the patent:
**01.04.2015 Bulletin 2015/14**

(51) Int Cl.:
***H01L 35/16*** (2006.01)   ***H01L 35/32*** (2006.01)
***H01L 35/34*** (2006.01)

(21) Application number: **09833805.6**

(22) Date of filing: **09.12.2009**

(86) International application number:
**PCT/US2009/067250**

(87) International publication number:
**WO 2010/071749 (24.06.2010 Gazette 2010/25)**

(54) **HIGH TEMPERATURE, HIGH EFFICIENCY THERMOELECTRIC MODULE**

THERMOELEKTRISCHES HOCHTEMPERATUR- UND HOCHLEISTUNGSMODUL

MODULE THERMOÉLECTRIQUE À RENDEMENT ÉLEVÉ ET À TEMPÉRATURE ÉLEVÉE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **12.11.2009 US 590653**
**19.12.2008 US 317170**

(43) Date of publication of application:
**19.10.2011 Bulletin 2011/42**

(73) Proprietor: **Hi-Z Technology, Inc.**
**San Diego, CA 92126 (US)**

(72) Inventors:
• **LEAVITT, Frederick, A.**
**San Diego**
**CA 92129 (US)**
• **ELSNER, Norbert, B.**
**La Jolla**
**CA 92037 (US)**
• **BASS, John, C.**
**La Jolla**
**CA 92037 (US)**
• **MCCOY, John, W.**
**San Diego**
**CA 92103 (US)**

(74) Representative: **Barton, Matthew Thomas et al**
**Forresters**
**Skygarden**
**Erika-Mann-Strasse 11**
**80636 München (DE)**

(56) References cited:
**GB-A- 1 013 265      JP-A- 2000 188 426**
**JP-A- 2008 192 694      US-A- 4 611 089**
**US-A- 5 625 245      US-A- 5 875 098**

**Description**

FIELD OF THE INVENTION

The present invention relates to thermoelectric modules and especially to high temperature thermoelectric modules.

CROSS REFERENCE TO RELATED APPLICATIONS

The present invention is a continuation-in-part of Serial No. 12/317,170 filed 12/19/2008.

BACKGROUND OF THE INVENTION

Thermoelectric Materials

The Seebeck coefficient of a thermoelectric material is defined as the open circuit voltage produced between two points on a conductor, where a uniform temperature difference of 1 K exists between those points.
The figure-of-merit of a thermoelectric material is defined as:

$$Z = \frac{\alpha^2 \sigma}{\lambda}$$,

where $\alpha$ is the Seebeck coefficient of the material, $\sigma$ is the electrical conductivity of the material and $\lambda$ is the total thermal conductivity of the material.
A large number of semiconductor materials were being investigated by the late 1950's and early 1960's, several of which emerged with Z values significantly higher than in metals or metal alloys. As expected no single compound semiconductor evolved that exhibited a uniform high figure-of-merit over a wide temperature range, so research focused on developing materials with high figure-of-merit values over relatively narrow temperature ranges. Of the great number of materials investigated, those based on bismuth telluride and lead telluride alloys emerged as the best for operating in various temperature ranges up to 600°C. Much research has been done to improve the thermoelectric properties of the above thermoelectric materials. For example n-type $Bi_2Te_3$ typically contains 5 to 15 percent $Bi_2Se_3$ and p-type $Bi_2Te_3$ typically contains 75 to 80 Mol percent $Sb_2Te_3$. Lead telluride is typically doped with Na and Te for P type behavior and Pb and I (iodine) for N type behavior.

Standard Designations

The temperature at which a thermoelectric alloy is most efficient can usually be shifted to higher or lower temperatures by varying the doping levels and additives. Some of the more common variations with PbTe alloys are designated in the thermoelectric industry as 3N and 2N for N type and 2P and 3P for P type. An in depth discussion of PbTe alloys and their respective doping compositions is given in the book edited by Cadoff and Miller, Chapter 10 "Lead Telluride Alloys and Junctions." For further understanding of $Bi_2Te_3$ based alloys and their doping, see two books edited by D.M. Rowe "CRC Handbook of Thermoelectrics, especially Chapter 19 and Thermoelectrics Handbook "Macro to Nano, Chapter 27. In this specification and in the claims the term PbTe is meant to include any lead and telluride semi-conductor alloy when both the lead and telluride Mol percentage is greater than 20 percent. This includes intrinsic or doped N or P type PbTe, PbSnMnTe and PbSnTe alloys, PbTe doped with Thallium, or $AgTe_2$.

Temperature Ranges for Best Performance

Thermoelectric materials can be divided into three categories: low, mid-range and high temperature.

Low Temperature

Commercially available low temperature materials are commonly based on $Bi_2Te_3$ alloys. When operated in air these materials can not exceed 250°C on a continuous basis. These alloys are mainly used for cooling although there are a number of waste heat recovery applications based on these alloys. When used as a power source, $Bi_2Te_3$ alloys

rarely exceed 5% efficiency.

Mid Range Temperature

Mid-range materials are normally based on the use of PbTe & TAGS. PbTe and can operate up to about 560°C and TAGS can operate at about 450 °C. Some Skutterudite based thermoelectric alloys (which are cobalt based alloys) are being investigated that also fall into this category but they exhibit high vaporization rates which must be contained for long life. All mid-range thermoelectric alloys known to Applicants will oxidize in air and must be hermetically sealed. Prior art PbTe alloys rarely exceed about 7 percent efficiency.

High Temperature - Primarily for Space Applications

High temperature thermoelectric materials are normally based on SiGe and Zintl alloys and can operate near 1,000 °C. Modules based on these alloys are difficult to fabricate, expensive and are normally used only in space applications. These prior art high temperature materials can achieve as much as 9 percent efficiency in some applications but they are not commercially viable. The reason 9% appears achievable is because of the large temperature difference that can be achieved with these alloys, which in turn increases efficiency.

Segmented Legs

A segmented thermoelectric leg preferably utilizes high temperature materials on the hot side of the leg and a low temperature material on the cold side of the legs. This arrangement improves the overall efficiency of the legs.
Some of the high temperature thermoelectric materials tend to experience high free vaporization rates (such as 50% loss in 300 hours). These modules can be sealed in a metal package referred to as a can. The process is called canning. Alternately, one fabricator has contained the material in Aerogel insulation in an attempt to suppress the evaporation. In another vapor suppression approach the sample was coated with 10 $\mu$m of titanium. Metal coatings can contribute to significant electrical and thermal shorting, if they remain un-reacted. Even if reacted, the coatings can still contribute to thermoelectric degradation.

Thermoelectric Modules

Electric power generating thermoelectric modules are well known. These modules produce electricity directly from a temperature differential utilizing the thermoelectric effect. The modules include P-type thermoelectric semiconductor elements and N-type thermoelectric semiconductor elements. These thermoelectric elements are called N-legs and P-legs. The effect is that a voltage differential of a few millivolts is created in each leg in the presence of a temperature difference of a few hundred degrees. Since the voltage differential is small, many of these elements (such as about 100 elements) are typically positioned in parallel between a hot surface and a cold surface and are connected electrically in series to produce potentials of a few volts. Thermoelectric modules are well suited to recover energy from a variety of waste heat applications because they are:

- Small      • Easily scaled up or down     • Solid state
- Highly reliable    • Silent        • Potentially cost effective

Hi-Z Prior Art Bismuth Telluride Molded Egg-Crate Modules

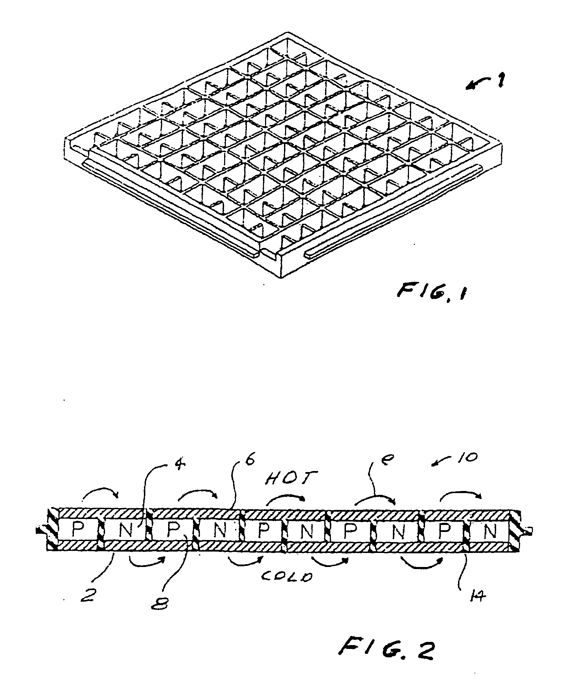

For example Hi-Z Technology, Inc., with offices in San Diego California, offers a Model HZ-14 thermoelectric bismuth telluride thermoelectric module designed to produce about 14 watts at a load potential of 1.66 volts with a 200°C temperature differential. Its open circuit potential is 3.5 volts. The module contains 49 N legs and 49 P legs connected electrically in series. It is a 0.5 cm thick square module with 6.27 cm sides. The legs are P-type and N-type bismuth telluride semiconductor legs and are positioned in an egg-crate type structure that insulates the legs from each other except where they are intentionally connected in series at the top and bottom surfaces of the module. That egg-crate structure which has spaces for the 98 legs is described in US Patent No. 5,875,098. The egg-crate is injection molded in a process described in detail in the patent. This egg-crate has greatly reduced the fabrication cost of these modules and improved performance for reasons explained in the patent. FIG. 1 is a drawing of the egg-crate and FIG. 2 is a cross sectional drawing of a portion of the egg-crate showing how the P-legs and N-legs are connected in series in the egg-crate. The curved arrows e show the direction of electron flow through bottom conductors 2, N legs 4, top conductors 6, and P legs 8 in this portion 10 of the module. Insulating walls 14 keep the electrons flowing in the desired series circuit.

Other $Bi_2Te_3$ thermoelectric modules that are available at Hi-Z are designed to produce 2.5 watts, 9 watts, 14 watts and 20 watts at the 200°C temperature differential. The term bismuth telluride is often used to refer to all combinations of $Bi_2Te_3$, $Bi_2Se_3$, $Sb_2Te_3$ and $Sb_2Se_3$. In this document where the term $Bi_2Te_3$ is used, it means any combination of $Bi_2Te_3$, $Bi_2Se_3$, $Sb_2Te_3$ and $Sb_2Se_3$.

Temperature Limitations

The egg-crates for the above described $Bi_2Te_3$ modules are injection molded using a thermoplastic supplied by Dupont under the trade name "Zenite". Zenite melts at a temperature of about 350°C. The thermoelectric properties of $Bi_2Te_3$ peak at about 100°C and are greatly reduced at about 250°C. For both of these reasons, uses of these modules are limited to applications where the hot side temperatures are lower than about 250°C.

Thermoelectric Materials - Figures of Merit

Thermoelectric Materials

Many different thermoelectric materials are available. These include bismuth telluride, lead telluride, silicon germanium, silicon carbide, boron carbide and many others. In these materials relative abundance can make huge differences in the thermoelectric properties. Much experimental data regarding these materials and their properties is available in the thermoelectric literature such as the CRC Handbook referenced above. Each of these materials is rated by their "figure of merit" which in all cases is very temperature dependent. Despite the fact that there exists a great need for non-polluting electric power and the fact that there exists a very wide variety of un-tapped heat sources; thermoelectric electric power generation in the United States and other countries is minimal as compared to other sources of electric power. The reason primarily is that thermoelectric efficiencies are typically low compared to other technologies for electric power generation and the cost of thermoelectric systems per watt generated is high relative to other power generating sources. Generally the efficiencies of thermoelectric power generating systems are in the range of about 5 percent.

Lead Telluride Modules

Lead telluride thermoelectric modules are also known in the prior art. A prior art example is the PbTe thermoelectric module described in US Patent No. 4,611,089 issued many years ago to two of the present inventors.
That module utilized lead telluride thermoelectric alloys with an excess of lead for the N legs and lead telluride with an excess of tellurium for the P legs. The thermoelectric properties of the heavily doped lead telluride thermoelectric alloys peak in the range of about 425 °C. The egg-crate for the module described in the above patent was fabricated using a technique similar to the technique used many years ago for making chicken egg crates using cardboard spacers. For the thermoelectric egg-crate the spacers were mica which was selected for its electrical insulating properties at high temperatures. Mica, however, is marginal in strength and cracks easily. A more rugged egg-crate material is needed.
FIG. 3 is a drawing from the 4,611,089 patent showing a blow-up of the module described in that patent. The egg-crate included a first set of parallel spacers 46a to 46k and a second set of spacers 48a to 48i. The N legs are shown at 52 and the P legs are shown at 54. The module included hot side conductors 56 and cold side conductors 58 to connect the legs in series as in the $Bi_2Te_3$ module described above.
That lead telluride module was suited for operation in temperature ranges in excess of 500°C. But the cost of fabrication of this prior art module is greatly in excess of the bismuth telluride module described above. Also, after a period of operation of about 1000 hours some evaporation of the P legs and the N legs at the hot side would produce cross contamination of all of the legs which would result in degraded performance.
What is needed is a low cost, high temperature, high efficiency thermoelectric module designed for operation at hot side temperatures in excess of 500°C preferably with thermoelectric properties substantially in excess of prior art high-temperature thermoelectric modules.

SUMMARY OF THE INVENTION

The present invention provides a long life, low cost, high-temperature, high efficiency thermoelectric module. Preferred embodiments include a two-part (a high temperature part and a low temperature part) egg-crate and segmented N legs and P legs. In preferred embodiments the legs are segmented into two or three segments. In preferred embodiments three segments are chosen for their chemical compatibility and/or their figure of merit in the various temperature ranges between the hot side and the cold side of the module. The legs include metal meshes partially embedded in thermoelectric segments to help maintain electrical contacts notwithstanding substantial differences in thermal expansions. In preferred embodiments a two-part molded egg-crate holds in place and provides insulation and electrical connections for the thermoelectric N legs and P legs. The high temperature part of the egg-crate is comprised of a ceramic material capable of operation at temperatures in excess of 500°C and the low temperature part is comprised of a liquid crystal polymer material having very low thermal conductivity. In preferred embodiments the high temperature ceramic is zirconium oxide and the liquid crystal polymer material is a DuPont Zenite available from DuPont in the form of a liquid crystal polymer resin. Preferably the module is sealed in an insulating capsule.

In preferred embodiments the high and intermediate temperature thermoelectric materials for the N legs are two types of lead telluride thermoelectric material (3N and 2N, respectively) and the low-temperature material is bismuth telluride. The high and intermediate temperature materials for the P legs are also lead telluride (3P and 2P, respectively). And the low temperature material is bismuth telluride. In preferred embodiments low temperature contacts are provided by thermally sprayed molybdenum-aluminum which provides excellent electrical contacts between the N and P legs. Iron metal mesh spacers are provided at the hot side to maintain electrical contact notwithstanding substantial thermal expansion variations. These mesh spacers may also be inserted between the lead telluride material and the bismuth telluride and/or between the different types of lead telluride material. These mesh spacers are flexible and maintain good contact and prevent or minimize cracking in the legs despite the expansion and contraction of the legs due to thermal cycling.

Module with Sixteen Percent Efficiency

A preferred embodiment is a thermoelectric module with approximately 16 percent conversion efficiency at a hot side temperature of 560 °C and a cold side of 50 °C. This module amalgamates numerous recent thermoelectric materials advances achieved by different groups with novel techniques developed by Applicants. This 16 percent efficiency is approximately double the efficiency presently available commercially. Adding a recently upgraded $Bi_2Te_3$ cold side segment to the PbTe legs increases the module efficiency by about 3 percentage points from about 8 percent as described in the background section to about 11 percent. An additional 5 digit increase in efficiency can be achieved by applying nano-grained technology as described below. The thermoelectric legs of preferred embodiments are fabricated using low-cost powder metallurgy. Segmented prefabricated legs may be bonded using a spot welding technique.

Fabrication Technique for PbTe/ $Bi_2Te_3$ N-type Leg

While adding a $Bi_2Te_3$ segment to the P leg is straight forward (PbTe powder is applied on top of $Bi_2Te_3$ material and the leg is cold pressed and sintered or hot pressed); fabricating a segmented PbTe/$Bi_2Te_3$ N-type leg poses a very special challenge because of anisotropy in the electrical conductivity of N-type $Bi_2Te_3$. If prepared by powder metallurgical processing, the $Bi_2Te_3$ leg will have five times the electrical resistivity in the pressing direction as compared to the resistivity in the direction perpendicular to the pressing direction. This eliminates all the most straight-forward fabrication processes from consideration, such as two layer conventional cold-press and sinter, or conventional diffusion bonding of hot-pressed materials. This is one of the principal reasons why N type PbTe/$Bi_2Te_3$ segmented leg technology has never been commercialized. Applicants have identified a processing route that achieves the required control of $Bi_2Te_3$ grain orientation while also producing a compatible diffusion bond between segments.

Special Cold Side Contacts

With a $Bi_2Te_3$ segment on the cold side of the PbTe leg it is possible to use Applicants' employer's standard prior art $Bi_2Te_3$ contacting methods as described in Patent No. 5,856,200, especially FIGS. 19A and 19B and related text.

This is a method of forming contacts to $Bi_2Te_3$ using thermal spraying of molybdenum and aluminum. The resultant cold side contact is firmly bonded to the legs and eliminates the need for numerous individual components. Instead of molybdenum and aluminum zinc may also be used.

Hot Side

Applicants have embedded iron mesh contacts into the PbTe to make a compliant thermal and electrical connection to an iron connector. This has several advantages. By embedding an iron mesh (or other compatible material) into PbTe the surface area of the contact can be much larger than the simple prior art planar contact of an iron shoe. In addition to the larger contact area, an embedded contact is held in place by mechanical forces as well as a metallurgical bond. The iron mesh is spot welded to the iron shoe. These metal meshes permit the modules to be utilized without the normally required compression between the hot and cold surfaces.

Hot Side Segment Compatibility with Iron Shoe

The most efficient P-type PbTe alloys known to Applicants are slightly tellurium excess. The excess Te acts as a P-type dopant. Te excess alloys however are not compatible with iron and are more reactive and volatile than PbTe alloys with excess tin and/or manganese. For these reasons in preferred embodiments the hot side segment in contact with the Fe shoe will contain a PbSnMnTe or PbSnTe alloy with a deficiency or no excess of tellurium.

Nano-Structures

A significant amount of work has been recently performed to create nano-sized thermoelectric material. Nano-sized materials have a large number of grain boundaries that impede the propagation of phonons through the material resulting in reduced thermal conductivity and increased ZT. To ensure a nano-sized structure, an inert fine material is added to the alloy that is in the form of nano-sized particulates. The fine additive results in prevention of grain growth and also impedes phonon propagation. This technique has been used with P type $Bi_2Te_3$ alloys. Applicants have demonstrated that similar reductions in thermal conductivity can be achievable in PbTe by fabricating it with nano-sized grains. Nano-sized grains can be achieved by ball milling, mechanical alloying, chemical processing and other techniques. Applicants have added nano-size alumina powder to nano-sized PbTe powder. These experiments indicated increased efficiencies and successfully inhibited grain growth at 800°C. This approach mimics the commercial oxide dispersion strengthened (ODS) alloys in which the micron sized oxides are added to prevent grain growth, greatly reduces creep and increases strength.

BRIEF DESCRIPTION OF THE DRAWINGS

FIG. 1 is a drawing of a prior art egg-crate for a thermoelectric module.
FIG. 2 is a drawing of a portion of a module with the FIG. 1 egg-crate.

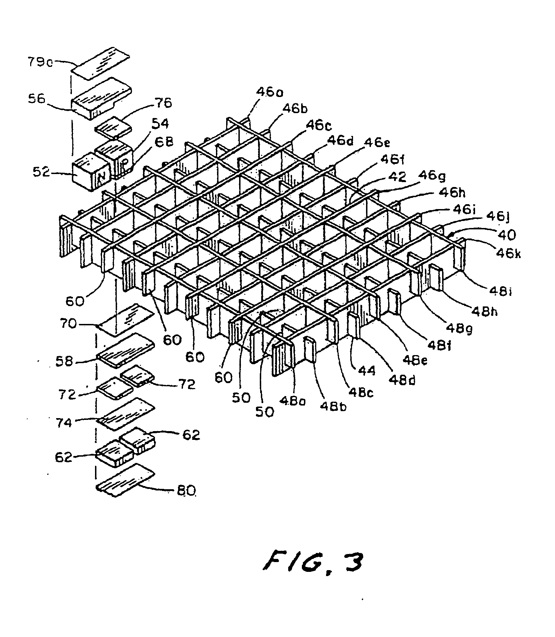

FIG. 3 is a prior art blown-up drawing of a prior art lead telluride thermoelectric module.
FIGS. 4 and 4A are drawings showing important features of a preferred embodiment of the present invention.
FIG. 5 is a drawing showing an application of the preferred embodiment used to generate electricity from the exhaust gas of a truck.
FIG. 5A shows an encapsulated module.
FIGS. 6A and 6B are graphs showing figures of merit for 2N, 3N, 2P and 3P lead telluride thermoelectric material and N and P bismuth telluride material.
FIGS. 7 and 7A are drawings showing portions of preferred thermoelectric modules.
FIGS. 8, 9 and 10 show a technique for making hot pressed thermoelectric legs.
FIGS. 11A, B and C show a molding technique for making modules of the present invention.
FIG. 12A and 12B demonstrate a process for making a preferred thermoelectric module.

DETAILED DESCRIPTION OF PREFERRED EMBODIMENTS

First Preferred Embodiment

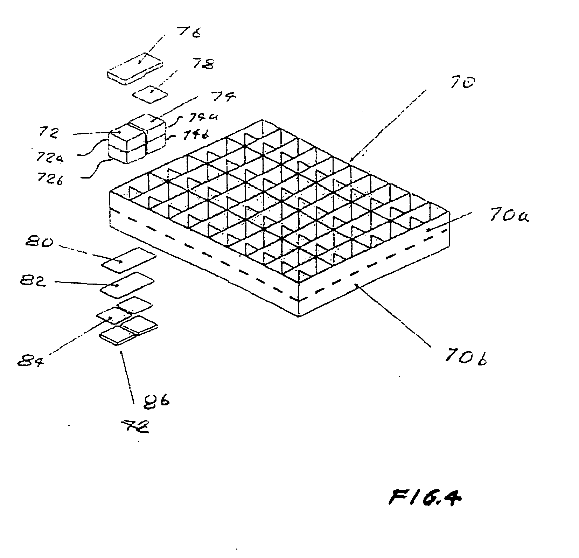

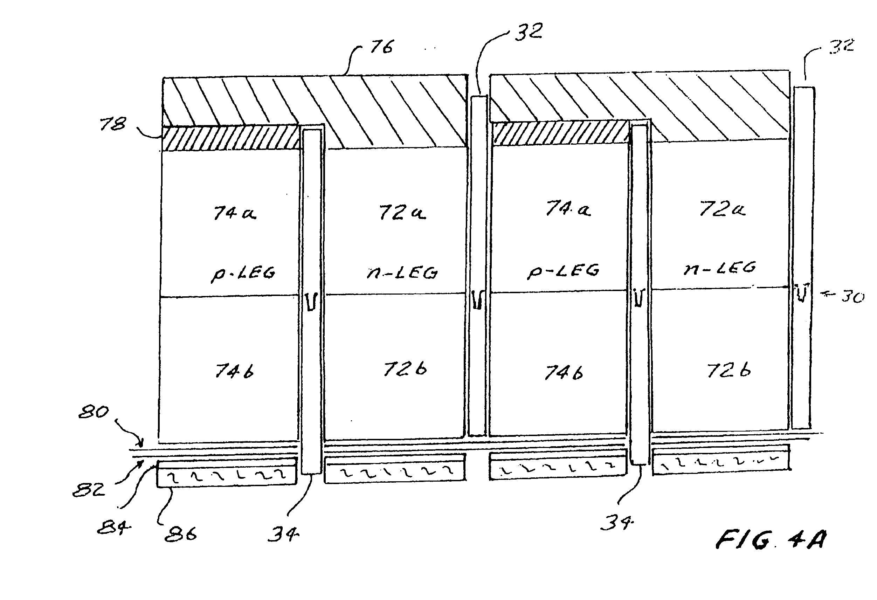

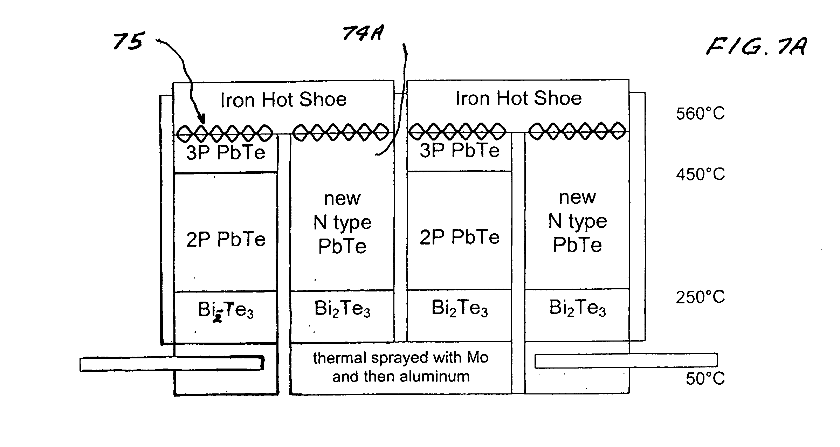

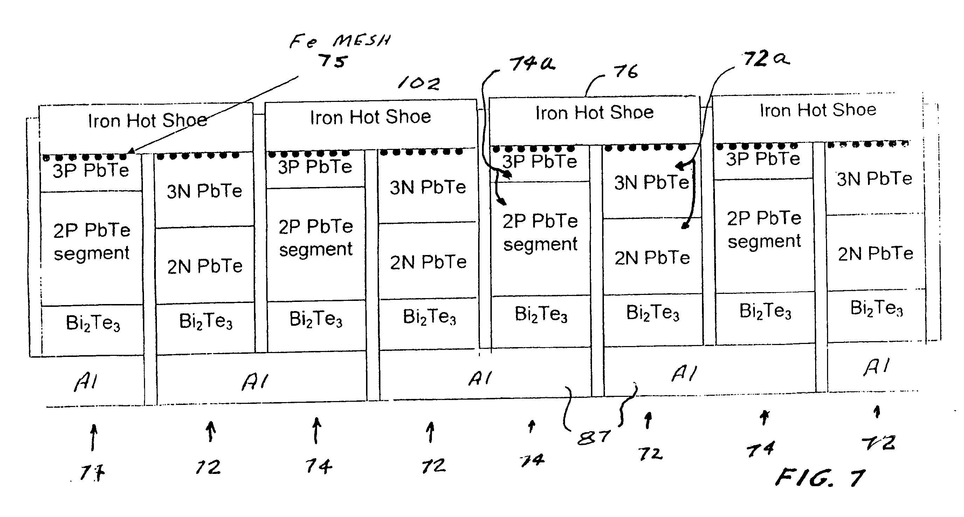

A first preferred embodiment of the present invention can be described by reference to FIGS. 4, 4A and 7. The FIGS. 4 and 4A drawings are from the parent application Serial No. 12/317,170, but this first preferred module is substantially improved and more efficient version than the embodiment described in parent patent application.

For example one significant difference is that the first preferred embodiment in this application utilizes three-segment thermoelectric legs in the module instead of only two. Specifically, for this preferred embodiment segments 72a and 74a as shown in FIGS. 4 and 4A are each comprised of two types of lead telluride material instead of only one type as in the parent application. This preferred embodiment is shown more specifically in FIG. 7 where the two types of lead telluride material in each leg are clearly shown. Details regarding the legs are provided below in the section entitled "Three Segment Thermoelectric Legs".

The Egg-Crate

Egg-crate 70 is injection molded using a technique similar to that described in Patent No. 5,875,098. However, the molding process in substantially more complicated. The egg-crate comes in two molded together sections. It includes a high temperature section (which will lie adjacent to a hot side) molded from stabilized zirconium oxide ($ZrO_2$). $ZrO_2$

has a very high melting point of 2715°C and a very low thermal conductivity for an oxide. The egg-crate also includes a lower temperature section (which will lie adjacent to a cold side) molded from Zenite Model 7130 available from DuPont that has a melting point of 350°C and has a very low thermal conductivity.

The $ZrO_2$ portion of the egg-crate is fabricated by injection molding of the $ZrO_2$ powders with two different binder materials. Some of the binder material is removed by leaching prior to sintering. The $ZrO_2$ portion is then sintered to remove the second binder and produce a part with good density and high temperature strength. The $ZrO_2$ portion will typically shrink about 20 percent during sintering. This sintered section is then placed in a second mold and a subsequent injection molding of the Zenite portion of the egg-crate is then performed, thereby bonding the Zenite to the $ZrO_2$. While the thermal conductivity of the $ZrO_2$ is among the lowest of any known oxide, its thermal conductivity of 2 W/mK is much higher than the thermal conductivity of Zenite which is 0.27 W/mK. An objective of the present invention is to minimize any loss of heat through the egg-crate material. Also the Zenite is flexible and will allow the two-section egg-crate to endure significant rough handling. The mica of the prior art patent is a relatively weak material that cracks easily. FIG. 4A shows a preferred technique for assuring a good bond between the $ZrO_2$ portion and the Zenite portion. A tab shown at 30 is molded at the bottom of the $ZrO_2$ walls 32. This increases the bonding surface between the $ZrO_2$ portion 32 and the Zenite portion 34 of the egg-crate walls.

Lead Telluride and Bismuth Telluride

Lead Telluride thermoelectric alloys allow thermoelectric modules to operate at higher temperatures than do modules based on bismuth telluride alloys and so have the potential to be much more efficient than bismuth telluride modules. Unlike bismuth telluride however, lead telluride is less ductile and cracks more readily than does bismuth telluride. This makes it difficult to build a bonded module and so most lead telluride modules are made by assembling many individual components that are subsequently held in compression with pressures as high as 6894757 pascal (1,000 psi). The high compressive force allows a bond to form between the lead telluride and the contact materials but these bonds break if the module is thermally cycled. The present invention provides a method of forming permanent bonds on both the hot and cold side of the module which eliminates the need for high compressive forces and permits thermally cycling without the substantial risk of breakage. This method includes the use in the legs of a mesh of conducting material such as an iron mesh. Details are provided in the sections that follow.

Three-Segment Thermoelectric Legs

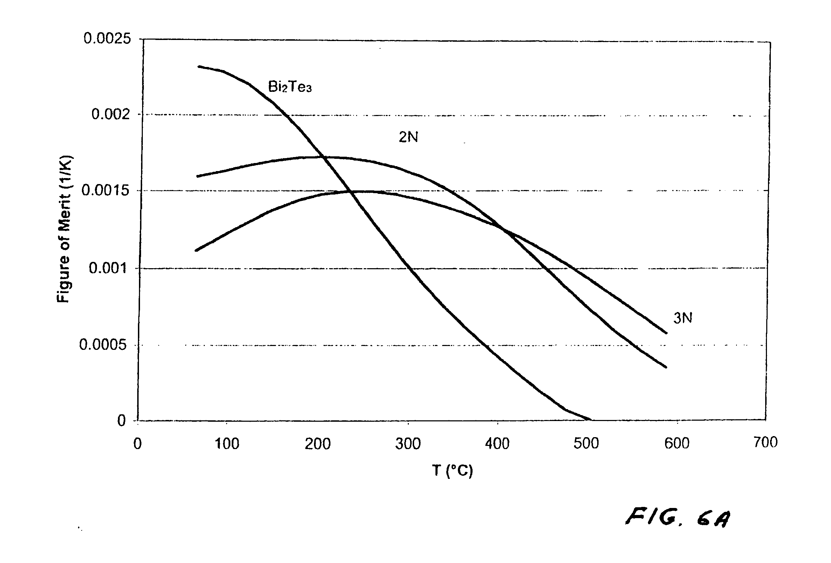

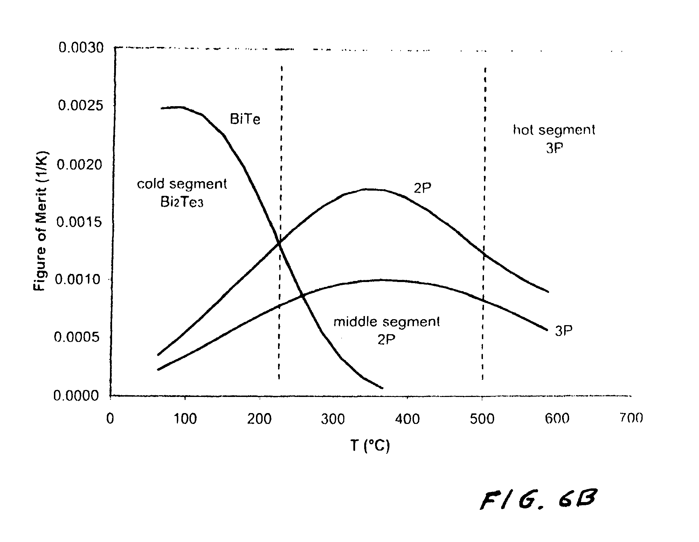

Important features of this first preferred embodiment of the present invention are shown in FIG. 7. The egg-crate is very similar to the one shown in FIGS. 4 and 4A. An important difference as indicated above is that the high-temperature thermoelectric material portion of the N legs are 3N and 2N lead telluride materials and 3P and 2P for the P legs as shown in FIG. 7 instead of only one type of lead telluride material. The designation 3N and 2N refer to PbTe doped for higher temperature operation and for lower temperature operation respectively. The designation 3P is for PbSnMnTe and 2P is for PbTe. While 2P doped with Na initially is better performing, it degrades due to Te vaporization. So 3P preferably is used instead because it does not vaporize significantly and can be used with the same Fe hot shoe as the N leg. FIGS. 6A and 6B illustrate, respectively for N and P PbTe legs, how the figure of merit for these alloys change as a function of temperature.

Bismuth telluride works best below about 250 °C. Bismuth telluride thermoelectric material is available form Marlow Industries with offices in Dallas, TX. Several successful methods are available for fabrication of PbTe materials and are described in "Lead Telluride Alloys and Junctions" of Thermoelectric Materials and Devices, Cadoff and Miller, published by Reinhold Publishing Corporation of New York. The bismuth telluride segments 72b and 74b are respectively doped with 0.1 Mol percent iodoform ($CHI_3$) to create the lower temperature N-type material and 0.1 part per million Pb to create lower temperature P-type material.

Fabricating 3N PbTe, 2N PbTe and $Bi_2Te_3$ Legs

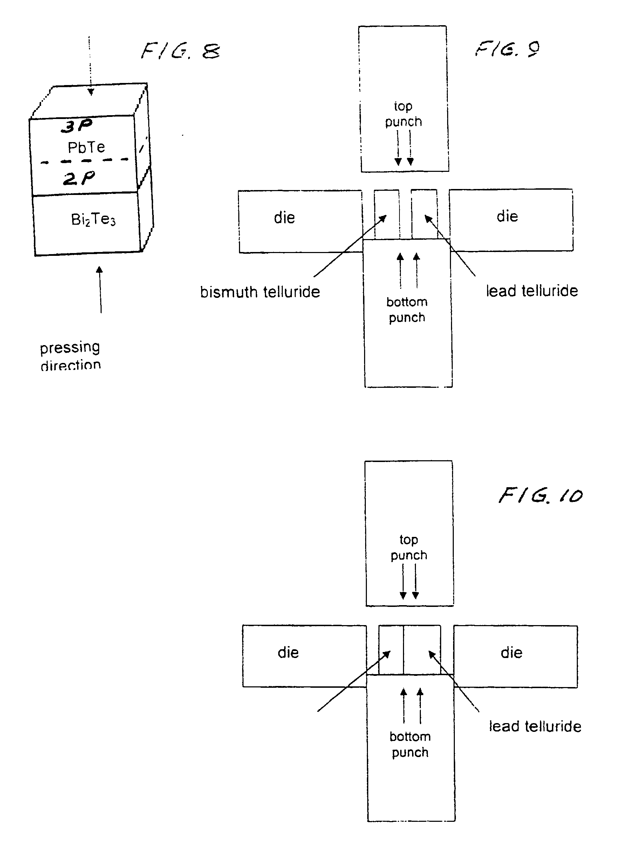

Making the thermoelectric legs for the second version of the first preferred embodiment is straight forward. P type $Bi_2Te_3$ powder can be simply cold pressed simultaneously with the lead telluride powders as shown in FIG. 8 and then sintered. (Note that the PbTe portion shown in FIG. 8 is 3P type and 2P type PbTe on top and $Bi_2Te_3$ at the bottom (colder side) of the leg.) This is because the thermoelectric properties for P type $Bi_2Te_3$ material are isotropic and so they are independent of the pressing direction. Segmenting N type $Bi_2Te_3$ material with PbTe elements is much more difficult because the thermoelectric properties for N type $Bi_2Te_3$ is anisotropic and the best properties are perpendicular to the pressing direction. This means that if an N type thermoelectric element was pressed with PbTe powder on the hot side and $Bi_2Te_3$ on the cold side as shown in FIG. 8, the $Bi_2Te_3$ properties in the pressing direction (which is the direction the heat would flow) would be poor. Two methods to fabricate a suitable segmented N type element may be used: 1) press separate and bond and 2) press separate then co-press. These are described below.

Press, Separate and Bond

This method consists of the following steps:

1) Press and sinter the PbTe segment.
2) Press and sinter the $Bi_2Te_3$ segment.
3) Rotate the $Bi_2Te_3$ segment so that it's best properties (perpendicular to the pressing direction) are in the correct orientation and insert the segment into a tight fitting die. If the die allows the $Bi_2Te_3$ segment to deform an excessive amount, the grains will rotate and the properties will be degraded.
4) Insert the PbTe segment so it rests snuggly against the $Bi_2Te_3$ segment. It may be useful to use an interface layer to aid in the bonding. One potential interface layer may be SnTe.
5) With a small force on the stack up, heat the segments to 400 °C in a reducing atmosphere for 48 hours.

And alternative to this method would be to:

1) Press and sinter the $Bi_2Te_3$ segment.
2) Rotate the $Bi_2Te_3$ segment so that it's best properties (perpendicular to the pressing direction) are in the correct orientation and insert the segment into a tight fitting die. If the die allows the $Bi_2Te_3$ segment to deform an excessive amount, the grains will rotate and the electrical properties will be degraded.
3) Fill the remainder of the die with PbTe powder. An interface layer such as SnTe may be useful.
4) Cold press and sinter the resultant element or the element could be hot pressed.

Press, Separate and Then Co-Press

During the pressing operation, N type $Bi_2Te_3$ grains become oriented in the plane perpendicular to the pressing direction. To make a useful pressed N type $Bi_2Te_3$ leg, the leg must be used so that the temperature gradient is perpendicular to the pressing direction of the element was pressed in. While this is simple to do with an unsegmented leg it is difficult to do this with a segmented leg because the powders from the two segments will tend to mix in the die and an accurate segment line will be difficult to achieve. The proposed method consists of pressing the two segments into low density blocks that contain the proper amount of material for the desired final segments and then inserting these pre-pressed blocks into a die that will be subsequently pressed perpendicular to the expected temperature gradient. The $Bi_2Te_3$ segment and the PbTe segment may be two separate pieces as shown in FIG. 9 or a single piece as shown in FIG. 10 and as described below:

1) Separately cold press the PbTe and the $Bi_2Te_3$ segment. The pellet should be low density and each segment should have the proper amount of material for the final leg. The two segments should be of a geometry small enough to fit into the die that will be used for the final press.
2) Place the segments (either one piece or two pieces) into a die that has the desired final geometry.
3) Press the pellet to the desired density. Because the pellet has a low density and because the die is larger than the pellet, the pellet will under go significant deformation during this second pressing operation. As the $Bi_2Te_3$ segment is pressed the movement caused by the punch will cause the $Bi_2Te_3$ grains to rotate into the desired orientation and result in optimum properties in the same direction as the intended temperature gradient. The die must be close to the same size as the pellet being pressed or the segment line will be too distorted.
4) Sinter the combined segments elements at 500 °C for 48 hours.

Steps 2, 3 and 4 can be replaced with a spot welding procedure. An Fe mesh or PbTe power may also be placed between the thermoelectric PbTe and BiTe segments and then spot welded in a process similar to spark sintering. In this process a current is sent through the segments and then the purposely placed interfacing resistance preferentially heats up and forms a low contact resistance point. The process time is less than one second.

Other Module Component

Other module components are shown in FIGS. 4A and 7A and 7B in two variation of this first preferred embodiment.

Three-Segment N-Legs and Three Segment P-Legs

The variation shown in FIG. 7 is similar to the one shown in FIG. 4A. At the top is hot conductor 76 comprised of iron metal. Below hot conductor 76 are an N Leg 72 and a P leg 74. The 3P portion of 74a of P leg 74 is in contact with iron conductor 76 and the 3N protion of leg 72a of N leg 72 is also in contact with the iron conductor 76. A graphite spacer 78 is not needed in this embodiment since the 3P segment 74a is compatable with iron as explained above. This module includes iron mesh compliant interface 75 that provides an electrically conductive interface between the PbTe interface and the iron hot shoe and also permits expansion and contraction of the N and P legs. In this version of the first preferred embodiment the cold conductor is zinc which is thermal sprayed onto the bottom of the module to rigidly fix the bottom of the N legs 72 and the P legs 74 to the structure of the egg-crate. The Pb compatibility foil 80 shown in FIG. 4 is not needed.

Three Segment P-Legs and Two Segment N-Legs

A second preferred embodiment of the present invention is shown in FIG. 7A. This embodiment is similar to the FIG. 7 embodiment. It combines the above techniques with existing state of the art materials to produce a cost effective thermoelectric module with an accumulated efficiency of 16 percent when operated between a hot side temperature of about 560 °C and 50 °C. The stack-up of improved efficiencies is shown in Table I. Commercially available PbTe materials can provide modules with efficiencies of 7 percent with the above temperature difference. In this preferred embodiment Applicants increase the efficiency to 9 percent by adding a P-type $Bi_2Te_3$ cold segment and further increase the efficiency to 10 percent by adding an N-type cold segment using a new $Bi_2Te_3$ material developed by Applicants. The efficiency is further increased to 11 percent by dividing the PbTe material into two segments, i.e. 2P and 3P. An improved PbTe material is used to gain another incremental improvement in efficiency to 12 percent as described in US patent application Serial No. 12/293,170.

Utilizing nano-grained $Bi_2Te_3$ available from GMZ Inc., with offices in West Chester, Ohio, provides another 1.0 percent to increase the accumulated efficiency to 13 percent and finally an additional 3 percent improvement is provided by use of nano-grained PbTe material to provide a module that operates at efficiencies of about 16 percent.

| Table 1 - Approaches to Improving Module Efficiency | | | |
|---|---|---|---|
| **Approach** | **Technology status** | **Digit Increase in efficiency** | **Accum. Efficiency** |
| Commercially available PbTe | Hi-Z fabricates | --- | 7% |
| P type $Bi_2Te_3$ cold segment | existing | 2% | 9% |
| N type $Bi_2Te_3$ cold segment | new | 1% | 10% |
| 2P with 3P hot segment | new/existing | 1 % | 11% |
| Vendor X, N type PbTe | new | 1% | 12% |
| Nanograined $Bi_2Te_3$ from GMZ Inc. | existing | 1% | 13% |
| Nanograined PbTe legs | new | 3% | 16% |

Technique to Prevent Te Evaporation and Contamination

As indicated in the background section life testing by Applicants of PbTe modules has shown that some degradation of the module occurs after approximately 1,000 hours of operation. Applicants have discovered that the degradation can be attributed to "crosstalk" between the N legs and the P legs near the hot junction caused by evaporation of tellurium from the P leg contaminating the N-leg. (As explained in the background section an excess of lead in the n-leg is what provides the n-leg with its thermoelectric doping properties.) The problem is prevented in preferred embodiments with two techniques: First, as shown in FIG. 4 the egg-crate walls separating the N legs from the P legs may be extended to contact the hot conductor 76 so that tellurium vapor is restrained from migrating to the n-leg. A second technique used by Applicants is to add a thin layer of PbSnMnTe at the top (hot side) of the p-legs (not shown in the drawings). This material is labeled 3P in FIGS. 7 and 7A. Applicants have determined that elemental tellurium exhibits little or no evaporation from PbSnMnTe. While the PbSnMnTe material does not have as good thermoelectric properties as PbTe, the amount used is small, only 0.51 millimeter (0.020 inch) long out of 11.43 millimeters (0.450 inch) overall length. The PbSnMnTe segments will be cold pressed and sintered with the 2P type PbTe and $Bi_2Te_3$ as shown in FIGS 7 and 7A. In some embodiments the PbSnMnTe material may be substituted for the hot portion of the p-legs.

Good Thermal and Electrical Conductivity

Compliant Metal Parts

The thermoelectric module of preferred embodiments will typically be placed between a hot surface of about 600°C and a cold surface of about 50°C. In many applications these temperatures may vary widely with temperature differentials swinging from 0°C to 550°C. Therefore the module and its components should be able to withstand these temperatures and these changes in temperature which will produce huge stresses on the module and its components. Both of the above versions of this embodiment is designed to meet these challenges.

Preferred embodiments shown in FIGS. 4A include a fiber metal compliant felt pad comprised of iron, copper or bronze wool. In the first version as shown at 86 in FIG. 4A the fiber metal mesh material is located at the bottom (cold side) of the module. For the embodiments shown in FIGS. 7 and 7A as shown at 75 the fiber mesh material is located at the top (hot side) of the module. These materials provide good thermal conductivity and are able to deform when the module is placed in compression between the heat source and heat sink. These materials are resilient to respond to thermal cycling and to the inevitable warping that the module will undergo because of the thermal gradient imposed across it. These compliant materials are also able to cushion the brittle lead telluride yet maintain intimate contact between it and the heat sinks. For the first version the fiber metal mesh pads can be impregnated with an elastomer such as silicone rubber to reduce the risk of creep and to add deflection and compliance. Silicone rubber can operate at temperatures up to 300 °C. In the second version portions of the mesh will become embedded in the lead telluride material to enhance electrical conductivity.

After being put in service the N and P type PbTe legs are creeping or pushing up towards the Fe hot shoe. A load of 6894757 pascal (1,000 psi) is initially used and can be reduced to 3447379 pascal (500 psi) after the module is operated for approximately 100 hours and proper seating of the module is obtained. After this time a lower load of 344738 to 689476 pascal (50 to 100 psi) used to maintain the low contact resistance joints. The same spot welding technique diesribed above can be applied to joining the Fe shoe/mesh to PbTe.

Additional Details on Second Version Hot Side

Solid iron hot shoes are formed that are sized appropriately to connect the hot side of the P leg to the hot side of the N leg. Tellurium excess formulations available in the industry such as 2P will react with iron. A suitable PbTe formulation is an alloy of PbTe and SnTe. MnTe may or may not be added. One example of a suitable P type element to contact the iron shoe is a thin hot side segment of 3P (a combination of PbTe, MnTe and SnTe), a segment of 2P (Te excess PbTe) below the 3P segment as shown in FIG. 7A and a cold side segment of $Bi_2Te_3$ below the 2P segment. To greatly increase the surface area of the hot side connector two layers of iron mesh are spot welded to the iron hot shoe. The spot weld area is minimal but allows the mesh to be flexible during thermal cycling and electrically conductive. The purpose of the spot weld is to aid in assembly and to provide a good electrical path from the mesh to the hot contact.

The hot shoes are then positioned on top of the lead telluride elements that are in the egg-crate as shown in FIGS. 7 and 7A. Keeping the cold side below 300°C the hot side of the module is then heated in an inert atmosphere to 600°C and then a load is gradually applied. The load is slowly increased until a pressure of about 6894757 pascal (1,000 psi) is reached. At this temperature the mesh will slowly embed into the PbTe and form an intimate bond. Because the mesh is free to move slightly with respect to the hot shoes the bond will experience minimal stress and will not break upon thermal cycling. The need for high pressure and high temperature joining can be eliminated if the spot welding bond is used.

Overall Module Design

The module is specifically designed to endure considerable thermal cycling or steady state behavior. The hot and cold side joints are free to slide and relieve thermal stresses. If the spot welded bonding method is not used the module initially needs to be held in compression at approximately 6894757 pascal (1,000 psi) after it reaches its design operating temperatures so the thermoelectric materials can creep into the Fe mesh. Once this "seat-in" operation is complete the module is well suited for reduced compression at about 344738 - 689476 pascal (50 - 100 psi) to ensure good heat transfer. The finished module is also well suited for "radiation coupled" heat sources with minimal or no mechanical connection to the module is made.

Alternate Bulk Alloys

Lead telluride based alloys have been used since the 1960s and the alloys and recommended doping levels were documented above. Their thermoelectric properties versus temperature are given in many publications such as Chapter 10, "Lead Telluride Alloys and Junctions" of Thermoelectric Materials and Devices, Cadoff and Miller, published by Reinhold Publishing Corporation of New York.

In the past four years newer PbTe based alloys have evolved that have better properties than the conventional PbTe based alloys noted above. For example a July 25, 2008 article in Science Daily reported on a lead telluride material developed at Ohio State University having substantial improvements in efficiency over prior art lead telluride materials. This new material is doped with thallium instead of sodium. The article suggests that the efficiency of the new material may be twice the efficiency of prior art lead telluride. Other experimenters have developed a new N type PbTe which is doped with Ti and iodine and has a ZT of 1.7 (PbTe is typically about 1.0). The P type alloy is $Pb_7Te_3$ and doped with AgTe. While it has the same ZT as PbTe 2P its advantage is that it can be used with Fe hot shoes segmented to $Bi_2Te_3$ alloys.

Applicants are seeking to prepare bulk lead telluride thermoelectric material with a finer grain size than has previously been achieved. Fine grain size is expected to lower the thermal conductivity of the material without significant impact on resistivity or Seebeck coefficient, thus raising its ZT and efficiency. In previous attempts others have made to produce a fine-grained PbTe, the grain size was observed to coarsen rapidly, even near room temperature, so the benefit of small grain size could not be retained. In this study, Applicants seek to preserve a fine grain structure by additions of very fine alumina powder, which is expected to produce a grain boundary pinning effect, thus stabilizing the fine grain size. Applicants' recent results indicate that the PbTe grain size can indeed be held below 2 $\mu$m, even with processing at 800°C.

Lead Telluride Only Modules

Some of the techniques described herein can be utilized in modules where the entire legs are comprised of only lead telluride thermoelectric alloys. Preferably, the lead telluride alloy or alloys are one or more of the newer very high efficient alloys.

Generator Design Using PbTe-Type Modules of the Preferred Embodiment

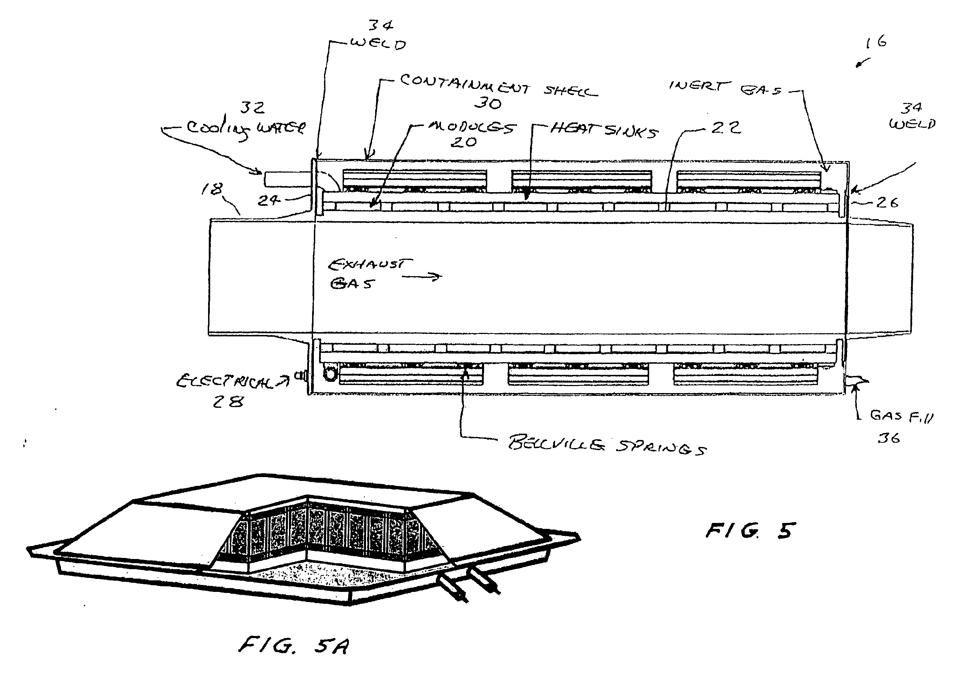

The high-temperature module of the preferred embodiment requires encapsulation to prevent oxidation of the N and P alloys with an accompanying decrease in thermoelectric properties. An example of encapsulating PbTe modules would be the 1 kW generator for diesel trucks shown at 16 in FIG. 5 since all of the modules are encapsulated together encapsulation of the individual modules is not necessary. In this example the generator is attached to a 12.7 centimeters (5-inch) diameter exhaust pipe 18. Lead telluride thermoelectric modules 20 are mounted on a support structure 22 which is machined to form an octagon. The inside surface is generally round with fins (not shown) which protrude into the gas stream to provide a greater heat transfer area. The basic design is similar to the design described in US Patent Number 5,625,245.

The casting of the support structure has two flanges 24 and 26, one large and one small which are perpendicular to the main part of the support structure. The large flange 24 is about 0.25 meter (10 inches) in diameter while the small flange 26 is about 0.20 meter (8 inches) in diameter.

The large flange contains feed-throughs for both the two electrical connections and four water connections. The two electric feed-throughs 28 are electrically isolated with alumina insulators from the support structure. Both the large and small flange will contain a weld preparation so a metal dust cover 30 can be welded in position.

The four water feed-through elements 32 consists of one inch diameter tubes that are welded into the flange. The inside portion of the water tubes are welded to a wire reinforced metal bellows hose with the other end connected to the heat sink by a compression fitting or a stainless to aluminum bimetallic joint. Two of the tubes are inlets and the other two tubes are outlets for the cooling water.

Once the generator is assembled and the flanges between the support structure and the dust cover are welded as shown at 34, the interior volume will be evacuated and back filled with an inert gas such as Argon through a small 9.53 millimeter (3/8 inch) diameter tube 36 in the dust cover to about 75% of one atmosphere when at normal room temperature (~ 20°c). Once filled, the fill tube will be pinched off and welded.

In a preferred embodiment nine thermoelectric modules 20 of the first preferred embodiment are mounted on each of the eight sides of the hexagonal structure for a total of 96 modules. Applicants estimate a total electrical output of about 1.1 kilowatts. This estimate is based on prior performance with the structure described in the 5,625,245 patent, utilizing modules of the first preferred embodiment and assuming an exhaust hot side temperature of about 550 °C and cold side cooling water temperature of about 100 °C.

Module Encapsulation

An alternative to encapsulation the entire generator, as shown in FIG. 5, is to encapsulate the individual modules.

FIG. 5A shows such a technique. This is an example where the module is encapsulated in a thin metal capsule which is comprised of a bottom plate 110 and a cover 112. The two parts are welded at the seam. The metal capsule requires a thin insulating sheet on both the hot side and the cold side. Capslues can also be formed with insulating material such as $SiO_2$.

Molded Egg-Crate with Legs in Place

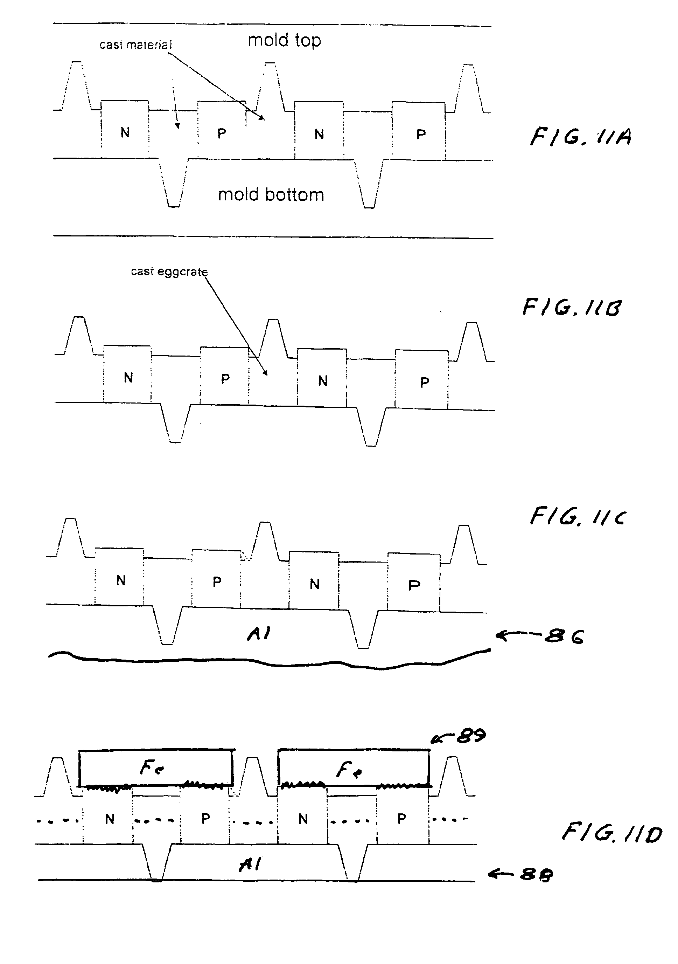

FIGS. 11A, B, C and D describe a technique for making the thermoelectric of the present invention by molding the egg-crate with the thermoelectric legs in place.

Thermoelectric egg-crates serve several functions. They hold the elements in the correct location, define the pattern of the cold side connectors and locates the hot side connectors. Egg-crates can be assembled from mica as described in US Patent Number 4611089, injection molded plastic as described in patent (gapless egg-crate) as described in US Patent Number 5,875,098 or injection molded ceramic or injection molded plastic and ceramic as described in parent application Serial No. 12/317,170. An alternative method of fabricating the egg-crate is proposed below:

1) A two-part mold is fabricated from a suitable material. Some possible mold materials are polyethylene, aluminum or Teflon. The mold is designed to hold the thermoelectric elements in place while a mold material is poured around the elements.

2) Thermoelectric elements are loaded into the top half of the mold assuring that the N and P elements are located appropriately as shown in FIG. 11A.

3) The bottom half of the mold is put in place and castable material is poured into the mold filling the spces labeled "cast material". Several choices are available for suitable castable materials. A two part epoxy would be suitable for low temperature applications. For high temperature applications Aremco's Ceramacast 584 or 645-N would be a good choice.

4) After the mold material has cured the part is removed from the mold and would appear as shown in FIG. 11B.

5) The cast egg-crate containing the thermoelectric elements is then ready to have the cold side contacts made as described in Patent No. 5,875,098. The loaded egg-crate is then fixtured appropriately to hold the elements in place while aluminum with a proper Mo bond coat is thermally sprayed onto the cold (bismuth telluride) side of the module. The result is as shown in FIG. 11C at 86. This process is explained in detail in Patent No. 4,611,089. An alternative metal to Mo/Al combination is zinc.

Unlike the gapless egg-crate modules described in Patent No. 5,875,098, only the cold side of the segmented module is connected in this manner. With the module held firmly to prevent warping, the deposited coating (MoAl or zinc) is sanded to expose the egg-crate walls which thereby define the cold side electrical connectors as described in Patent No. 5,875,098. The module is then lapped to a suitable finish and the bottom (cold side) will appear as shown at 88 in FIG. 11D. Iron shoes provide the electrical connections as shown at 89 in FIG.11D.

Using a slightly different mold design, a high temperature mold material could be used for the hot side of the module and a low thermal conductivity material could be used for the cold side as suggested by the dashed line in FIG. 11D. Ideally, a two part egg-crate with the cold side being a polymer/organic based material for strength and the hot side being a ceramic based material for high temperature resistance would be the best choice.

Composite Egg-crate Module

Following are techniques for fabricating the module:

1. Slice and dice castings of the N and P portions of the PbTe and Bi2Te3 materials. Alternately, fabricate the leg portions by powder metallurgy techniques.
2. Join the PbTe and Bi2Te3 portions of the segmented legs by spot welding or plasma spark sintering.
3. Assemble legs in a thermoplastic molded egg-crate similar to the prior art egg-crate shown in FIG. 1 to form a series circuit.
4. Thermal spray the cold side of the module with Zinc.
5. Lap down the Zinc deposit to form a smooth surface and electrically isolate the N and P legs except where they need to be connected. At this point the N and P legs are joined on the cold side and the legs extend out of the egg-crate on the hot side. The top of the eggcrate is expected to operate at less than 250°C.

6. To insulate and strengthen the extended N and P legs for use at 560°C, mica layers are stacked up around the extending N and P legs. Between the mica sheets are thin layers of opacified quartz paper. The mica sheets are stacked high enough to contain the Fe shoes. Each of the Fe shoes as described above have two layers of Fe mesh spot welded to the surface that engages the PbTe legs.

7. The module is operated at 560°C under compression for several hours to permit the iron mesh to partially bind to the PbTe. This firmly connects the PbTe legs to the iron shoes. The module can then be operated under compression or can be heated by radiation under no compressive load. Alternately, the Fe shoe and mesh can be spot welded to the N and P PbTe legs.

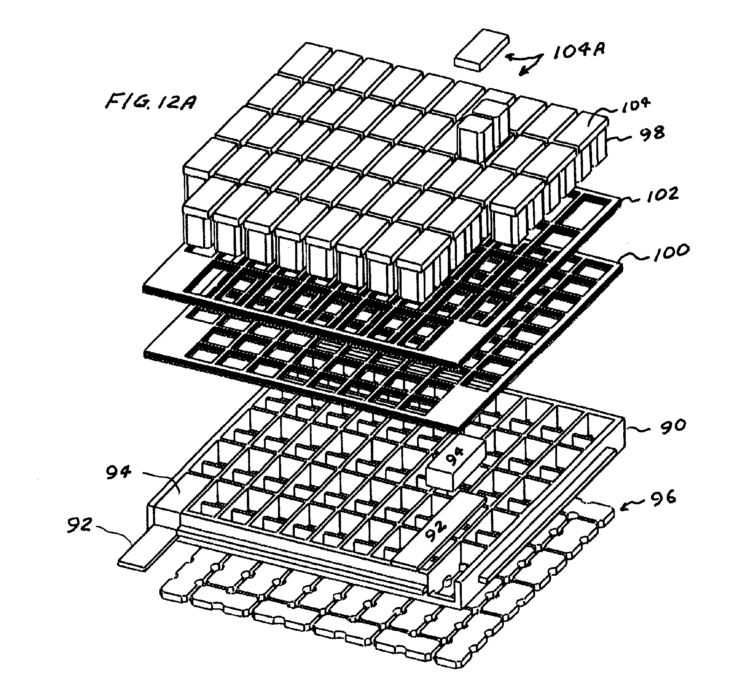

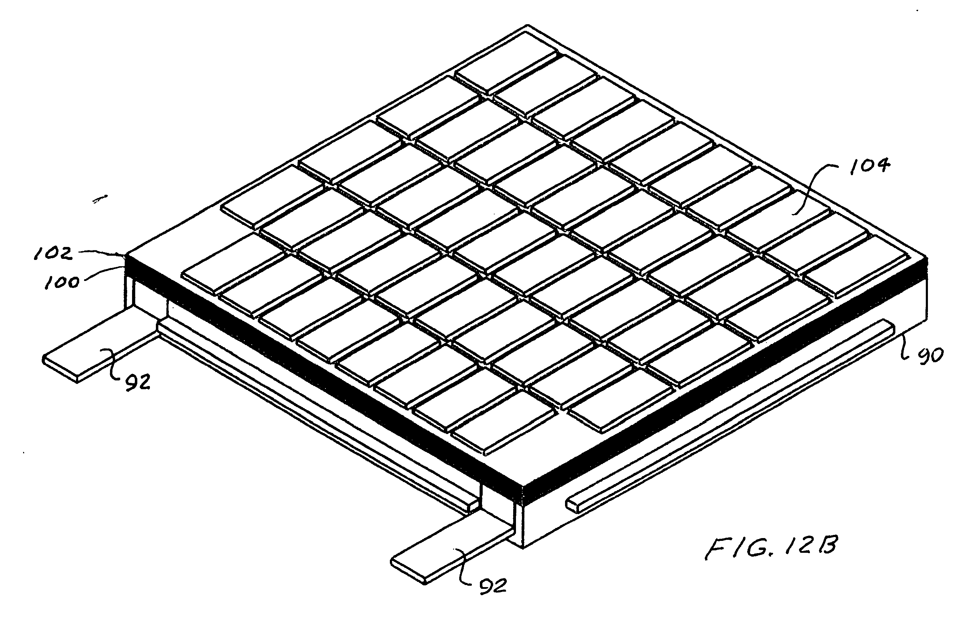

FIGS. 12A and 12B show features of this composite egg-crate module. FIG. 12A is an exploded view of the module and FIG. 12B show the completed module, prior to it being sealed. The thermoplastic molded egg-crate is shown at 90. Copper leads are shown at 92 and copper anchor spacers are shown at 94. The zinc cold side contacts (which are thermal sprayed and lapped down are shown at 96. The ninety six thermoelectric legs are shown at 98. As explained above the bottom parts of the legs are contained within the walls of the thermoplastic egg-crate and the top part of the legs extend above the walls of the egg-crate. Five thin checkerboard mica spacers with ninety six square holes for each of the ninety six legs are shown stacked closely on each other at 100. These spacers together have a thickness equal to the length of the legs extending above the walls of the thermoplastic egg-crate portion of the module. Another five mica spacers are shown at 102. These spacers have 48 rectangular holes to fit around the hot side iron shoes which are shown at 104. One of these shoes are shown at 104A along with two legs poking up in the drawing to demonstrate how the iron shoes connect the N and P legs at the hot side. Iron mesh is spot welded to the iron shoes and partially diffuses into the legs as described above, but the mesh is not shown in the drawing. The completed module except for its encapsulation is shown in FIG. 12B.

Preferred Module

An example of a module that incorporates the features described above will have the following properties:

| | |
|---|---|
| Module width | 6.0 cm |
| Module depth | 7.5 cm |
| Module thickness | 1.0 cm |
| Hot side temperature | 560 °C |
| Cold side Temperature | 50 °C |

40 P type legs - each P leg is 6.3 mm long, 5.7 mm wide and 5.7 mm deep. The bottom (cold side) 2.2 mm is bismuth telluride and the top 1 mm is 3P.
40 N type legs - each N leg is 6.3 mm long, 5.7 mm wide and 5.7 mm deep. The bottom (cold side) 1.6 mm is bismuth telluride and the top 1.3 mm is 3P.
Knowing the thermal conductivity of the thermoelectric alloys and how it changes with temperature gradient along the length of the leg is calculated and the segment line for each thermoelectric alloy is positioned as indicated in FIG. 6A and 6B. According to these figures the $Bi_2Te_3$ segment on the N leg would be positioned so that its center is at 200 °C. The 3N segment on the hot side on the N leg should be positioned so that its center is at 420 °C. The 3P segment on the hot side of the P leg is there to be compatible with the iron shoe and avoid Te vaporization so it should be made as thin as possible and still form a reliable separation between the 2P material and the iron shoe. Preferably that thickness is about 1 mm.
Performance specifications are as follows:

| | |
|---|---|
| Power | 40 watts |
| Open circuit voltage | 9.6 volts |
| Voltage at matched load | 4.8 volts |
| Internal resistance | 0.57 ohms |
| Heat flux | 9.4 W/cm2 |
| Efficiency (max) | 10% |

Variations

While the above description contains many specificities, the reader should not construe these as limitations on the scope of the invention, but merely as exemplifications of preferred embodiments thereof. For example:

Other High Temperature Thermoelectric Alloys

Some of the other thermoelectric alloys that are attractive over high-temperature ranges are:

Si-20% Ge, LaTe$_{1.4}$ type alloys
Zintl, (Yb$_{14}$MnSb$_{11}$)
TAGS (AgSbTe$_2$)$_{.15}$(GeTe)$_{.85}$
The skutterudites such as CoSb$_4$ type alloys
The half-Huesler alloys

The LAST and FAST Alloys of Michigan State University

All of these bulk alloys and others under development can be used in the new ZrO2/Zenite egg-crate design shown in Figure 4 or the other eggcrate designs that are described herein.

Thin Film Quantum Well Modules

The egg-crates of the present invention could be utilized with thin film quantum well thermoelectric P and N legs of the type described in detail in US Patent No. 5,550,387. That patent describes N and P thermoelectric legs that are fabricated using alternating layers 10 nanometers thick of Si/Si$_{0.8}$Ge$_{0.2}$ layers grown on silicon substrates. In applications with temperatures above 500°C these legs would be used on the cold side. That patent and patent 6,828,579 also disclose high temperature lattices comprised of thin layers of B$_4$C/B$_9$C and Si/SiC can be operated at very high temperatures up to about 1100°C. Details for fabricating B$_4$C/B$_9$C thermoelectric legs are provided in US Patent No. 6,828,579 (assigned to Applicants' employer). See especially Col. 3 where high temperature performance is discussed. These B$_4$C/B$_9$C and Si/SiC materials could also be used alone to make thermoelectric legs which could be used in the egg-crate of the present invention or on the hot side of the legs along with bismuth telluride or quantum well Si/SiGe for the cold side.

A large number of 10 nm quantum well layers are built up on a compatible substrate that has a low thermal conductivity to produce quantum well thermoelectric film. Kapton is a good substitute candidate if the temperature is not too high. For higher temperature operation silicon is a preferred choice of substrate material as described in Col. 11 of Patent No. 6,828,579. Other substrate materials are discussed in Col. 7. A good substrate material not disclosed in the patent is porous silicon. Porous silicon can survive very high temperatures and has extremely low thermal conductivity. The pores can be produced in silicon film such as 5 micron thick film from one side to extend to within a fraction of a micron of the other side. The pores can be produced either before the thermoelectric layers are laid down or after they are laid down.

The quantum well thermoelectric film is cut and combined to make n and p type legs of the appropriate size and each leg is loaded into one opening of the FIG. 4 egg-crate. Before loading the hot and cold ends of the N and P legs are metallized to yield a low contact resistance on the cold side. Electrical contacting materials of Pb foil and Cu connecting straps are then assembled followed by the Al$_2$O$_3$ spacer and Cu felt. The module is then turned over and the graphite piece is placed against the P leg, followed by the iron conductor strap which contacts the graphite and the N type PbTe.

Other Fabrication Techniques

Segmented Legs

Separate portions of the segmented legs can be readily bonded together by passing a current through both using a spot welding machine sometimes also referred to as spark sintering. As the current passes through the samples, the interface, which is purposely made to have a high resistance, reach a temperature at which bonding takes place. Sometimes a liquid phase is formed. The spot welding time is only a fraction of a second. To form a consistent bond, wire mesh has been used. The mesh preferentially heats up and imbeds itself in both materials. The N type Bi$_2$Te$_3$, which must be used in the correct orientation, retained its crystalline orientation and was successfully bonded to N type PbTe. The contact resistance between the two components was less than 100 $\mu\Omega/cm^2$ and the bond was strong. This bonding technique was also successful for bonding the P leg PbTe and Bi$_2$Te$_3$ segments.

The PbTe portions of the p-legs can also be cold pressed and sintered separately from the Bi$_2$Te$_3$ portions. When they are subject to hot operating conditions they will diffusion bond. The same applies to the n-legs.

Hot Pressing of the Legs

Another option is to hot press the thermoelectric materials in bulk then slice and dice them into legs.

Other Crate Designs

Aerogel Crate

In one variation, an aerogel material is used to fill all unoccupied spaces in the egg-crate. A module assembly will be sent to an aerogel fabrication laboratory. They will immerse it in silica sol immediately after dropping the pH of the sol. The sol converts to silica gel over the next few days. It is then subjected to a supercritical drying process of tightly controlled temperature and pressure condition in a bath of supercritical liquid $CO_2$. This process removes all the water in the gel and replaces it with gaseous $CO_2$. The Aerogel serves multiple functions: (1) helping to hold the module together, (2) reducing the sublimation rate of the PbTe and (3) providing thermal and electrical insulation around the legs.

In another variation, an egg-crate made of non-woven refractory oxide fiber material, possibly with a fugitive polymer binder, and having the consistency of stiff paper or card stock is used. After assembly, the binder is burned away, leaving a porous fiber structure that is them infiltrated with Aerogel. The fiber reinforcement of the aerogel gives added strength and toughness.

**Claims**

1. A high-temperature lead telluride thermoelectric module comprising:

   A. a two-part egg-crate (70) for holding in place and providing insulation and electrical connections (28, 89) for a number of thermoelectric N-legs (4, 52, 72) and P-legs (8, 54, 74), wherein said egg-crate (70) is comprised of:

   1) a hot side part comprised of a ceramic material capable of operation at temperatures in excess of 500°C and
   2) a cold side part comprised of a polymeric material having very low thermal conductivity;

   B. a plurality of segmented thermoelectric N-legs (4, 52, 72) and P-legs (8, 54, 74), each leg comprised of at least one PbTe segment (72a, 74a) and positioned in said egg-crate (70), at least a portion (10) of said legs being electrically connected in series;
   wherein

   1) each of at least a plurality of said N-legs (4, 52, 72) are comprised of

   a) a high-temperature thermoelectric segment (72a, 74a), wherein the high-temperature is in excess of 500°C,
   b) a low-temperature thermoelectric segment (72b, 74b) and
   c) at least one metal mesh (75) at least partially embedded in the high-temperature segment (72a, 74a); and

   2) each of at least a plurality of said P-legs (8, 54, 74) are comprised of

   a) a high-temperature thermoelectric segment (72a, 74a), wherein the high-temperature is in in excess of 500°C,
   b) a low-temperature thermoelectric segment (72b, 74b) and
   c) at least one metal mesh (75) at least partially embedded in the high-temperature segment (72a, 74a).

2. The high-temperature lead telluride thermoelectric module as in Claim 1 wherein at least a plurality of said low-temperature thermoelectric segments (72b, 74b) are comprised of BiTe.

3. The high-temperature lead telluride thermoelectric module as in Claim 1 wherein each of a plurality of said N-legs (4, 52, 72) also comprises at least one intermediate temperature PbTe segment.

4. The high-temperature lead telluride thermoelectric module as in Claim 1 wherein at least one segment of said N-leg (4, 52, 72) and at least one segment of said P-leg (8, 54, 74) is comprised of at least 30 mol percent lead and at least 30 mol percent telluride.

5. The high-temperature lead telluride thermoelectric module as in Claim 1 wherein each of a plurality of said P-legs (8, 54, 74) also comprises at least one intermediate temperature PbTe segment.

6. The high-temperature lead telluride thermoelectric module as in Claim 2 wherein said plurality of said lead-telluride thermoelectric N-legs (4, 52, 72) and P-legs (8, 54, 74) are electrically connected with one or more metals thermally sprayed on one side of the module defining a cold side.

7. The high-temperature lead telluride thermoelectric module as in Claim 6 wherein said one or more metals is zinc.

8. The high-temperature lead telluride thermoelectric module as in Claim 6 wherein said one or more metals is molybdenum and aluminum.

9. The thermoelectric module as in Claim 1 wherein said ceramic material is zirconium oxide and said polymeric material is in the form of a liquid crystal polymer resin.

10. The thermoelectric module as in Claim 1 wherein said ceramic material is comprised of thin stacked sheets of mica.

11. The high-temperature lead telluride thermoelectric module as in Claim 1 wherein a plurality of said thermoelectric legs comprise fine micron/nano-sized grains.

12. The high-temperature lead telluride thermoelectric module as in Claim 9 wherein the cold side part and the hot side part are joined together at a tab (30) and socket junction.

13. The high-temperature lead telluride thermoelectric module as in Claim 1 wherein each N-leg (4, 52, 72) and P-leg (8, 54, 74) of at least a plurality of pairs of said thermoelectric N-legs (4, 52, 72) and P-legs (8, 54, 74) are electrically connected utilizing an iron shoe (89).

14. The high-temperature lead telluride thermoelectric module as in Claim 13 wherein each of a plurality of said iron shoes (89) are electrically connected to the pair of N-legs (4, 52, 72) and P-legs (8, 54, 74) with at least two spot-welded metal meshes (75).

15. The high-temperature lead telluride thermoelectric module as in Claim 14 wherein said metal meshes (75) are iron meshes.

16. The thermoelectric module as in Claim 1 wherein metal meshes (75) are provided in each leg at an interface between segments to maintain proper electrical contacts notwithstanding substantial temperature variations.

17. The thermoelectric module as in Claim 15 wherein the metal meshes (75) at the interfaces are impregnated with an elastomer.

18. The thermoelectric module as in Claim 17 wherein the elastomer is silicone rubber.

19. The high-temperature lead telluride thermoelectric module as in Claim 1 wherein at least a plurality of the segments of said thermoelectric legs are electrically connected to at least one other segment with a metal mesh (75).

20. The thermoelectric module as in Claim 1 wherein the module is sealed in an insulating capsule.

21. The thermoelectric module as in Claim 1 wherein the module is combined with other similar modules to provide a thermoelectric generator.

22. The thermoelectric module as in Claim 13 wherein the thermoelectric generator is adapted to provide electric power from the waste heat of a motor vehicle.

23. The thermoelectric module as in Claim 15 wherein the egg-crate (70) walls separating the N-legs (4, 52, 72) from the P-legs (8, 54, 74) are adapted to contact the hot conductor so that tellurium vapor is restrained from migrating to the N-leg (4, 52, 72).

24. The thermoelectric module as in Claim 7 wherein at least a plurality of the P-legs (8, 54, 74) comprise a thin layer of PbSnMnTe at their hot sides.

25. The thermoelectric module as in Claim 7 wherein at least a plurality of the P-legs (8, 54, 74) comprise a thin layer of SnTe at their hot sides.

**Patentansprüche**

1. Bleitellurid basiertes thermoelektrisches Hochtemperaturmodul, umfassend:

A. eine zweiteilige Eierkiste (70) um elektrische Verbindungen (28, 89) für eine Anzahl thermoelektrischer N-Beine (4, 52, 72) und P-Beine (8, 54, 74 in Position zu halten und Isolierung bereitzustellen, wobei die genannte Eierkiste (70) aus Folgendem besteht:

1) einem heißseitigen Teil, der aus einem Keramikmaterial besteht, das fähig ist mit Temperaturen von über 500 °C zu arbeiten und
2) einem kaltseitigen Teil, der aus einem Polymermaterial besteht, das sehr niedrige Wärmeleitfähigkeit aufweist;

B. eine Vielzahl segmentierter thermoelektrischer N-Beine (4, 52, 72) und P-Beine (8, 54, 74), wobei jedes Bein aus wenigstens einem PbTe-Segment (72a, 74a) besteht und in der genannten Eierkiste (70) positioniert ist, wobei wenigstens ein Abschnitt (10) der genannten Beine elektrisch in Reihe geschaltet ist; wobei

1) jedes von wenigstens einer Vielzahl der genannten N-Beine (4, 52, 72) besteht aus

a) einem thermoelektrischen Hochtemperatursegment (72a, 74a), wobei die Hochtemperatur über 500 °C beträgt,
b) einem thermoelektrischen Niedertemperatursegment (72b, 74b) und
c) wenigstens einem Metallgitter (75), das wenigstens teilweise in das Hochtemperatursegment (72a, 74a) eingebettet ist; und

2) jedes von wenigstens einer Vielzahl der genannten P-Beine (8, 54, 74) besteht aus

a) einem thermoelektrischen Hochtemperatursegment (72a, 74a), wobei die Hochtemperatur über 500 °C beträgt,
b) einem thermoelektrischen Niedertemperatursegment (72b, 74b) und
c) wenigstens einem Metallgitter (75), das wenigstens teilweise in das Hochtemperatursegment (72a, 74a) eingebettet ist.

2. Bleitellurid basiertes thermoelektrisches Hochtemperaturmodul nach Anspruch 1, wobei wenigstens eine Vielzahl der genannten thermoelektrischen Niedertemperatursegmente (72b, 74b) aus BiTe besteht.

3. Bleitellurid basiertes thermoelektrisches Hochtemperaturmodul nach Anspruch 1, wobei jedes einer Vielzahl der genannten N-Beine (4, 52, 72) außerdem wenigstens ein PbTe-Segment Mitteltemperatur umfasst.

4. Bleitellurid basiertes thermoelektrisches Hochtemperaturmodul nach Anspruch 1, wobei wenigstens ein Segment des genannten N-Beins (4, 52, 72) und wenigstens ein Segment des genannten P-Beins (8, 54, 74) aus wenigstens 30 Molprozent Blei und wenigstens 30 Molprozent Tellurid besteht.

5. Bleitellurid basiertes thermoelektrisches Hochtemperaturmodul nach Anspruch 1, wobei jedes einer Vielzahl der genannten P-Beine (8, 54, 74) außerdem wenigstens ein PbTe-Segment Mitteltemperatur umfasst.

6. Bleitellurid basiertes thermoelektrisches Hochtemperaturmodul nach Anspruch 2, wobei die Vielzahl der genannten thermoelektrischen N-Beine (4, 52, 72) und P-Beine (8, 54, 74), die auf Bleitellurid basieren, elektrisch mit einem oder mehreren Metallen verbunden sind die thermisch auf eine Seite des Moduls gesprüht wurden, welche eine kalte Seite definiert.

7. Bleitellurid basiertes thermoelektrisches Hochtemperaturmodul nach Anspruch 6, wobei das/die genannte(n) Metall(e) Zink ist/sind.

8. Bleitellurid basiertes thermoelektrisches Hochtemperaturmodul nach Anspruch 6, wobei das/die genannte(n) Metall(e) Molybdenum und Aluminium ist/sind.

9. Thermoelektrisches Modul nach Anspruch 1, wobei das genannte Keramikmaterial Zirconoxid ist und das genannte Polymermaterial in Form eines Flüssigkristallpolymerharzes ist.

10. Thermoelektrisches Modul nach Anspruch 1, wobei das genannte Keramikmaterial aus dünnen, gestapelten Glimmerplatten besteht.

11. Bleitellurid basiertes thermoelektrisches Hochtemperaturmodul nach Anspruch 1, wobei eine Vielzahl der genannten thermoelektrischen Beine Feinmikron-/nanoskalige Körnchen umfasst.

12. Bleitellurid basiertes thermoelektrisches Hochtemperaturmodul nach Anspruch 9, wobei der kaltseitige Teil und der heißseitige Teil an einer Flacksteckverbindung (30) zusammengefügt sind.

13. Bleitellurid basiertes thermoelektrisches Hochtemperaturmodul nach Anspruch 1, wobei jedes N-Bein (4, 52, 72) und P-Bein (8, 54, 74) von wenigstens einer Vielzahl von Paaren der genannten thermoelektrischen N-Beine (4, 52, 72) und P-Beine (8, 54, 74) unter Verwendung eines Eisenschuhs (89) elektrisch verbunden sind.

14. Bleitellurid basiertes thermoelektrisches Hochtemperaturmodul nach Anspruch 13, wobei jeder einer Vielzahl der genannten Eisenschuhe (89) elektrisch mit dem Paar von N-Beinen (4, 52, 72) und P-Beinen (8, 54, 74) mit wenigstens zwei punktgeschweißten Metallgittern (75) verbunden ist.

15. Bleitellurid basiertes thermoelektrisches Hochtemperaturmodul nach Anspruch 14, wobei die genannten Metallgitter (75) Eisengitter sind.

16. Thermoelektrisches Modul nach Anspruch 1, wobei die Metallgitter (75) in jedem Bein an einer Schnittstelle zwischen Segmenten bereitgestellt sind, um ungeachtet erheblicher Temperaturschwankungen elektrische Kontakte beizubehalten.

17. Thermoelektrisches Modul nach Anspruch 15, wobei die Metallgitter (75) an den Schnittstellen mit einem Elastomer imprägniert sind.

18. Thermoelektrisches Modul nach Anspruch 17, wobei das Elastomer Silikongummi ist.

19. Bleitellurid basiertes thermoelektrisches Hochtemperaturmodul nach Anspruch 1, wobei wenigstens eine Vielzahl der Segmente der genannten thermoelektrischen Beine elektrisch mit wenigstens einem anderen Segment mit einem Metallgitter (75) verbunden ist.

20. Thermoelektrisches Modul nach Anspruch 1, wobei das Modul in einer Isolierkapsel abgedichtet ist.

21. Thermoelektrisches Modul nach Anspruch 1, wobei das Modul mit anderen ähnlichen Modulen kombiniert ist, um einen thermoelektrischen Generator bereitzustellen.

22. Thermoelektrisches Modul nach Anspruch 13, wobei der thermoelektrische Generator angepasst ist, elektrische Energie aus der Abwärme eines Motorfahrzeugs bereitzustellen.

23. Thermoelektrisches Modul nach Anspruch 15, wobei die Eierkistenwände (70), welche die N-Beine (4, 52, 72) von den P-Beinen (8, 54, 74) trennen, angepasst sind, den heißen Leiter zu kontaktieren, sodass Telluriumdampf beeinträchtigt wird, zum N-Bein (4, 52, 72) zu migrieren.

24. Thermoelektrisches Modul nach Anspruch 7, wobei wenigstens eine Vielzahl der P-Beine (8, 54, 74) eine dünne Schicht PbSnMnTe an ihren heißen Seiten aufweist.

**25.** Thermoelektrisches Modul nach Anspruch 7, wobei wenigstens eine Vielzahl der P-Beine (8, 54, 74) eine dünne Schicht SnTe an ihren heißen Seiten aufweist.

**Revendications**

**1.** Module thermoélectrique au tellurure de plomb à haute température comprenant :

A. un casier alvéolé en deux parties (70) pour maintenir en place et fournir une isolation et des connexions électriques (28, 89) à un certain nombre de jambes N (4, 52, 72) et de jambes P (8, 54, 74) thermoélectriques, ledit casier alvéolé (70) comprenant :

1) une partie latérale chaude constituée d'un matériau céramique capable de fonctionner à des températures supérieures à 500 °C ; et
2) une partie latérale froide constituée d'un matériau polymère présentant une conductivité thermique très faible ;

B. plusieurs jambes N (4, 52, 72) et jambes P (8, 54, 74) thermoélectriques segmentées, chaque jambe étant constituée d'au moins un segment de PbTe (72a, 74a) et positionnée dans ledit casier alvéolé (70), au moins une partie (10) desdites jambes étant connectée électriquement en série ;
dans lequel

1) chaque jambe N d'au moins plusieurs desdites jambes N (4, 52, 72) est constituée de :

a) un segment thermoélectrique à haute température (72a, 74a), dans lequel la température est supérieure à 500 °C ;
b) un segment thermoélectrique à basse température (72b, 74b) ; et
c) au moins une grille métallique (75) au moins en partie intégrée au segment à haute température (72a, 74a) ; et

2) chaque jambe P d'au moins plusieurs desdites jambes P (8, 54, 74) est constituée de :

a) un segment thermoélectrique à haute température (72a, 74a), dans lequel la température est supérieure à 500 °C ;
b) un segment thermoélectrique à basse température (72b, 74b) ; et
c) au moins une grille métallique (75) au moins en partie intégrée au segment à haute température (72a, 74a).

**2.** Module thermoélectrique au tellurure de plomb à haute température selon la revendication 1, dans lequel au moins plusieurs desdits segments thermoélectriques à basse température (72b, 74b) sont constitués de BiTe.

**3.** Module thermoélectrique au tellurure de plomb à haute température selon la revendication 1, dans lequel chaque jambe N de plusieurs desdites jambes N (4, 52, 72) est aussi constituée d'au moins un segment de PbTe à température intermédiaire.

**4.** Module thermoélectrique au tellurure de plomb à haute température selon la revendication 1, dans lequel au moins un segment de ladite jambe N (4, 52, 72) et au moins un segment de ladite jambe P (8, 54, 74) sont constitués d'au moins 30 % de plomb en mole et d'au moins 30 % de tellurure en mole.

**5.** Module thermoélectrique au tellurure de plomb à haute température selon la revendication 1, dans lequel chaque jambe P de plusieurs desdites jambes P (8, 54, 74) est aussi constituée d'au moins un segment de PbTe à température intermédiaire.

**6.** Module thermoélectrique au tellurure de plomb à haute température selon la revendication 2, dans lequel lesdites plusieurs jambes N (4, 52, 72) et jambes P (8, 54, 74) thermoélectriques au tellurure de plomb sont connectées électriquement à un ou plusieurs métaux pulvérisés thermiquement sur un côté du module définissant un côté froid.

7. Module thermoélectrique au tellurure de plomb à haute température selon la revendication 6, dans lequel ledit ou lesdits métaux sont le zinc.

8. Module thermoélectrique au tellurure de plomb à haute température selon la revendication 6, dans lequel ledit ou lesdits métaux sont le molybdène et l'aluminium.

9. Module thermoélectrique selon la revendication 1, dans lequel le matériau céramique est l'oxyde de zirconium et ledit matériau polymère se trouve sous la forme d'une résine polymère à cristaux liquides.

10. Module thermoélectrique selon la revendication 1, dans lequel ledit matériau céramique est constitué de fines feuilles empilées de mica.

11. Module thermoélectrique au tellurure de plomb à haute température selon la revendication 1, dans lequel plusieurs desdites jambes thermoélectriques comprennent des grains fins micro/nano-dimensionnés.

12. Module thermoélectrique au tellurure de plomb à haute température selon la revendication 9, dans lequel la partie latérale froide et la partie latérale chaude sont jointes ensemble au niveau d'une jonction de type languette (30) et logement.

13. Module thermoélectrique au tellurure de plomb à haute température selon la revendication 1, dans lequel chaque jambe N (4, 52, 72) et chaque jambe P (8, 54, 74) d'au moins plusieurs paires desdites jambes N (4, 52, 72) et jambes P (8, 54, 74) thermoélectriques sont connectées électriquement au moyen d'une semelle en fer (89).

14. Module thermoélectrique au tellurure de plomb à haute température selon la revendication 13, dans lequel chaque semelle en fer de plusieurs desdites semelles en fer (89) est connectée électriquement à la paire de jambes N (4, 52, 72) et de jambes P (8, 54, 74) avec au moins deux grilles métalliques soudées par point (75).

15. Module thermoélectrique au tellurure de plomb à haute température selon la revendication 14, dans lequel lesdites grilles métalliques (75) sont des grilles en fer.

16. Module thermoélectrique selon la revendication 1, dans lequel des grilles métalliques (75) sont produites dans chaque jambe au niveau d'une interface entre les segments afin de maintenir des contacts électriques appropriés malgré des variations de température considérables.

17. Module thermoélectrique selon la revendication 15, dans lequel les grilles métalliques (75) aux interfaces sont imprégnées d'un élastomère.

18. Module thermoélectrique selon la revendication 17, dans lequel l'élastomère est un caoutchouc de silicone.

19. Module thermoélectrique au tellurure de plomb à haute température selon la revendication 1, dans lequel au moins plusieurs des segments desdites jambes thermoélectriques sont connectés électriquement à au moins un autre segment avec une grille métallique (75).

20. Module thermoélectrique selon la revendication 1, le module étant scellé dans une capsule isolante.

21. Module thermoélectrique selon la revendication 1, le module étant combiné avec d'autres modules similaires afin de fournir un générateur thermoélectrique.

22. Module thermoélectrique selon la revendication 13, dans lequel le générateur thermoélectrique est conçu pour fournir de l'énergie électrique à partir de la chaleur perdue d'un véhicule à moteur.

23. Module thermoélectrique selon la revendication 15, dans lequel les parois du casier alvéolé (70) séparant les jambes N (4, 52, 72) des jambes P (8, 54, 74) sont conçues pour entrer en contact avec le conducteur chaud de manière à empêcher la vapeur de tellure de migrer vers les jambes N (4, 52, 72).

24. Module thermoélectrique selon la revendication 7, dans lequel au moins plusieurs des jambes P (8, 54, 74) sont constituées d'une fine couche de PbSnMnTe au niveau de leurs côtés chauds.

**25.** Module thermoélectrique selon la revendication 7, dans lequel au moins plusieurs des jambes P (8, 54, 74) sont constituées d'une fine couche de SnTe au niveau de leurs côtés chauds.

FIG. 1

FIG. 2

FIG. 3

FIG.4

FIG. 4A

34
WELD

16

CONTAINMENT SHELL
30

INERT GAS

32
COOLING WATER

MODULES
20

HEAT SINKS

22

34
WELD

18

24

26

EXHAUST
GAS →

ELECTRICAL
28

BELLVILLE SPRINGS

GAS Fill
36

FIG. 5

FIG. 5A

EP 2 377 174 B1

FIG. 6A

*FIG. 6B*

FIG. 7A

FIG. 7

FIG. 8

3P

PbTe

- - - -

2P

Bi₂Te₃

pressing
direction

FIG. 9

top
punch

die                die

bismuth telluride

bottom
punch

lead telluride

FIG. 10

top
punch

die                die

bottom
punch

lead telluride

cast material

mold top

N    P    N    P

mold bottom

*FIG. 11A*

cast eggcrate

N    P    N    P

*FIG. 11B*

*FIG. 11C*

N    P    N    P

Al

← 86

← 89

Fe    Fe

N    P    N    P

Al

*FIG. 11D*

← 88

FIG. 12A

EP 2 377 174 B1

FIG. 12B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 12317170 B
- US 5875098 A
- US 4611089 A
- US 5856200 A
- US 293170 A
- US 5625245 A
- US 5550387 A
- US 6828579 B

**Non-patent literature cited in the description**

- Lead Telluride Alloys and Junctions. **CADOFF ; MILLER.** Thermoelectric Materials and Devices. Reinhold Publishing Corporation